(19) **Europäisches Patentamt**
**European Patent Office**
**Office européen des brevets**

(11) **EP 2 227 834 B1**

(12) **EUROPÄISCHE PATENTSCHRIFT**

(45) Veröffentlichungstag und Bekanntmachung des Hinweises auf die Patenterteilung:
**03.08.2011 Patentblatt 2011/31**

(21) Anmeldenummer: **08867452.8**

(22) Anmeldetag: **19.12.2008**

(51) Int Cl.:
*H01L 35/16* *(2006.01)*    *H01L 35/34* *(2006.01)*
*B21C 23/00* *(2006.01)*

(86) Internationale Anmeldenummer:
**PCT/EP2008/068085**

(87) Internationale Veröffentlichungsnummer:
**WO 2009/083508 (09.07.2009 Gazette 2009/28)**

(54) **EXTRUSIONSVERFAHREN ZUR HERSTELLUNG VERBESSERTER THERMOELEKTRISCHER MATERIALIEN**

EXTRUSION PROCESS FOR PRODUCING IMPROVED THERMOELECTRIC MATERIALS

PROCEDE D'EXTRUSION POUR PRODUCTION DE MATERIAUX THERMOELECTRIQUES AMELIORES

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **28.12.2007 EP 07150470**

(43) Veröffentlichungstag der Anmeldung:
**15.09.2010 Patentblatt 2010/37**

(73) Patentinhaber: **BASF SE**
**67056 Ludwigshafen (DE)**

(72) Erfinder:
- **KUEHLING, Klaus**
  **67158 Ellerstadt (DE)**
- **STERZEL, Hans-Josef**
  **67125 Dannstadt-Schauernheim (DE)**
- **HAASS, Frank**
  **64390 Erzhausen (DE)**

(56) Entgegenhaltungen:
| | |
|---|---|
| EP-A- 0 115 950 | EP-A- 1 215 736 |
| WO-A-01/17034 | WO-A-2007/104601 |
| JP-A- 2003 078 178 | US-A- 3 220 199 |
| US-A- 3 285 019 | US-A- 3 285 786 |
| US-A- 4 161 111 | US-B1- 6 313 392 |

**Beschreibung**

Die vorliegende Erfindung betrifft Verfahren zur Verminderung der Wärmeleitfähigkeit und zur Erhöhung des thermoelektrischen Wirkungsgrads von thermoelektrischen Materialien auf Basis von Bleichalcogeniden.

Thermoelektrische Generatoren und Peltier-Anordnungen als solche sind seit langem bekannt. p- und n-dotierte Halbleiter, die auf einer Seite erhitzt und auf der anderen Seite gekühlt werden, transportieren elektrische Ladungen durch einen äußeren Stromkreis, wobei an einem Verbraucher im Stromkreis elektrische Arbeit verrichtet werden kann. Der dabei erzielte Wirkungsgrad der Konversion von Wärme in elektrische Energie wird thermodynamisch durch den Carnot-Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Bis heute werden jedoch nur Wirkungsgrade unterhalb von 10 % erzielt.

Legt man andererseits einen Gleichstrom an eine derartige Anordnung an, so wird Wärme von einer Seite zur anderen Seite transportiert. Eine derartige Peltier-Anordnung arbeitet als Wärmepumpe und eignet sich deshalb zur Kühlung von Apparateteilen, Fahrzeugen oder Gebäuden. Auch die Heizung über das Peltier-Prinzip ist günstiger als eine herkömmliche Heizung, weil immer mehr Wärme transportiert wird als dem zugeführten Energieäquivalent entspricht.

Gegenwärtig werden thermoelektrische Generatoren unter anderem in Raumsonden zur Erzeugung von Gleichströmen, für den kathodischen Korrosionsschutz von Pipelines, zur Energieversorgung von Leucht- und Funkbojen, zum Betrieb von Radios und Fernsehapparaten eingesetzt. Die Vorteile der thermoelektrischen Generatoren liegen in ihrer äußersten Zuverlässigkeit. So arbeiten sie unabhängig von atmosphärischen Bedingungen wie Luftfeuchte; es erfolgt kein störungsanfälliger Stofftransport, sondern nur ein Ladungstransport; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit passt sich die thermoelektrische Energiewandlung äußerst flexibel in künftige Bedürfnisse wie Wasserstoffwirtschaft oder Energieerzeugung aus regenerativen Energien ein.

Eine besonders attraktive Anwendung wäre der Einsatz zur Wandlung in elektrische Energie in elektrisch betriebenen Fahrzeugen. Hierfür braucht keine Änderung am vorhandenen Tankstellennetz vorgenommen zu werden. Allerdings sind für eine derartige Anwendung in der Regel Wirkungsgrade größer als 10 % erforderlich.

Auch die Umwandlung solarer Energie direkt in elektrische Energie ist sehr attraktiv. Konzentratoren wie Parabolrinnen können die Sonnenenergie auf thermoelektrische Generatoren bündeln, wodurch elektrische Energie erzeugt wird.

Aber auch zur Nutzung als Wärmepumpe sind höhere Wirkungsgrade notwendig.

Thermoelektrisch aktive Materialien werden im Wesentlichen anhand ihres Wirkungsgrades bewertet. Kennzeichnend für thermoelektrische Materialien ist diesbezüglich der so genannte Z-Faktor (figure of merit):

$$Z = \frac{S^2 \cdot \sigma}{\kappa}$$

mit dem Seebeck-Koeffizienten S, der elektrischen Leitfähigkeit $\sigma$ und der Wärmeleitfähigkeit $\kappa$. Bevorzugt sind thermoelektrische Materialien, die eine möglichst geringe Wärmeleitfähigkeit, eine möglichst große elektrische Leitfähigkeit und einen möglichst großen Seebeck-Koeffizienten aufweisen, so dass der figure of merit einen möglichst hohen Wert annimmt.

Das Produkt $S^2\sigma$ wird als Powerfaktor bezeichnet und dient vor allem dem Vergleich ähnlicher thermoelektrischer Materialien.

Zu generellen Vergleichszwecken wird darüber hinaus oftmals das dimensionslose Produkt Z·T (thermoelektrischer Wirkungsgrad) angegeben. Bisher bekannte thermoelektrische Materialien weisen maximale Werte von Z·T von ungefähr 1 bei einer optimalen Temperatur auf. Jenseits dieser optimalen Temperatur sind die Werte von Z·T oft deutlich niedriger als 1.

Eine genauere Analyse ergibt, dass der Wirkungsgrad $\eta$ sich ergibt aus

$$\eta = \frac{T_{hoch} - T_{niedrig}}{T_{hoch}} \cdot \frac{M-1}{M + \dfrac{T_{niedrig}}{T_{hoch}}}$$

mit

$$M = \left[ 1 + \frac{Z}{2}\left(T_{hoch} + T_{niedrig}\right) \right]^{\frac{1}{2}}$$

(siehe auch Mat. Sci. and Eng. B29 (1995) 228).

Das Ziel ist damit, ein thermoelektrisch aktives Material bereitzustellen, welches einen möglichst hohen Wert für Z bzw. Z T und eine hohe realisierbare Temperaturdifferenz aufweist. Aus der Sicht der Festkörperphysik sind hierbei viele Probleme zu bewältigen:

Ein hohes $\sigma$ bedingt eine hohe Elektronenbeweglichkeit im Material, d.h. Elektronen (oder Löcher bei p-leitenden Materialien) dürfen nicht stark an die Atomrümpfe gebunden sein. Materialien mit hoher elektrischer Leitfähigkeit $\sigma$ weisen meist gleichzeitig eine hohe Wärmeleitfähigkeit auf (Wiedemann - Franzsches Gesetz), wodurch Z nicht günstig beeinflusst werden kann. Gegenwärtig eingesetzte Materialien wie $Bi_2Te_3$ stellen schon Kompromisse dar. So wird die elektrische Leitfähigkeit durch Legieren weniger herabgesetzt als die Wärmeleitfähigkeit. Deshalb setzt man vorzugsweise Legierungen ein wie z.B. $(Bi_2Te_3)_{90}(Sb_2Te_3)_5(Sb_2Se_3)_5$ oder $Bi_{12}Sb_{23}Te_{65}$.

Für thermoelektrische Materialien mit hohem Wirkungsgrad sind vorzugsweise noch weitere Randbedingungen zu erfüllen. Vor allem müssen sie hinreichend temperaturstabil sein, um unter Betriebsbedingungen über Jahre hinweg ohne wesentlichen Wirkungsgradverlust arbeiten zu können. Dies bedingt eine hochtemperaturstabile Phase an sich, eine stabile Phasenzusammensetzung und eine zu vernachlässigende Diffusion von Legierungsbestandteilen in die anliegenden Kontaktmaterialien.

Die WO 01/17034 beschreibt die Herstellung von thermoelektrischen Materialien auf Basis von zwei oder mehr Elementen aus der Gruppe Bi, Sb, Te und Se durch Extrusion von pulverförmigen oder kompaktierten Legierungspulvern. Durch die Heißextrusion sollen interne mikroskopische Defekte vermindert werden und damit gute thermoelektrische und mechanische Eigenschaften erhalten werden.

F. Belanger et al. beschreiben in Advances In Powder Metallurgy & Particulate Materials - 2001, Proceedings of the 2001 International Conference on Powder Metallurgy & Particulate Materials, May 13 to 17, 2001, New Orleans, Seiten 9-88 bis 9-98 die Verbesserung der thermoelektrischen Eigenschaften von Bismuttellurid-Legierungen durch Steigerung der Mikrostruktur durch Extrusion.

Die Herstellung von thermoelektrischen Elementen durch Extrusion ist in allgemeiner Form in US 3,220,199 beschrieben. Neben anderen Materialien werden auch Bleitelluride als Materialien erwähnt. Spezifische Extrusionsbedingungen sind aber nur für Bismuttelluride angegeben. Es wird ein Flussmittel eingesetzt, und die hergestellten Körper haben einen Querschnitt von mindestens 20 mm$^2$.

Die hydrostatische Extrusion von thermoelektrischen Materialien ist allgemein in der US 4,161,111 beschrieben. Dabei wird auch auf Bleitellurid eingegangen.

US 3,285,019 betrifft zweiphasige thermoelektrische Körper, enthaltend eine Bleitellurid-Matrix. In Beispiel 3 wird die Heißextrusion bei 300°C beschrieben. Eigenschaften für die Produkte bzw. Eigenschaftsänderungen sind nicht explizit angesprochen.

In der EP-A-0 115 950 wird jedoch zur US-Schrift Stellung genommen und angegeben, dass das aus der Extrusion resultierende Material eine verminderte Wärmeleitfähigkeit habe.

WO 2007/104601 betrifft dotierte Bleitelluride für thermoelektrische Anwendungen. Es ist angegeben, dass das gemahlene Material heiß oder kalt extrudiert werden kann.

WO 01/17034 betrifft ein Verfahren zur Herstellung thermoelektrischer Materialien. Bei den Materialien handelt es sich nicht um Bleitelluride, sondern um Bismuthtelluride, Antimontelluride, Bismuthselenide oder Antimonselenide. Es ist angegeben, dass die Materialien verbesserte mechanische und thermoelektrische Eigenschaften aufweisen. Für die Extrusion wird eine Temperatur zwischen Raumtemperatur und 550°C, bevorzugt zwischen 320 und 490°C angegeben. Der Druck beträgt 960 bis 8500 kg/cm2.

Für die Extrudierungsverfahren werden vorteilhafte thermoelektrische Eigenschaften nur in sehr allgemeiner Form beschrieben. Für Bleitelluride sind keine derartigen Eigenschaften angegeben.

Aufgabe der vorliegenden Erfindung ist die Bereitstellung eines Verfahrens zur Verminderung der Wärmeleitfähigkeit und zur Erhöhung des thermoelektrischen Wirkungsgrads von thermoelektrischen Materialien, z. B. auf Basis von Bleichalcogeniden, insbesondere Bleitelluriden.

4a Die Aufgabe wird erfindungsgemäß dadurch gelöst, dass die thermoelektrischen Materialien bei einer Temperatur unterhalb ihres Schmelzpunkts und einem Druck im Bereich von 300 bis 1000 MPa extrudiert werden und die Temperatur bei der Extrusion 500 bis 630 °C beträgt.

Es wurde erfindungsgemäß gefunden, dass durch die Extrusion der Bleichalcogenide bei einer Temperatur unterhalb ihres Schmelzpunktes und einem Druck im Bereich von 300 bis 1000 MPa kompakte, homogene Materialien zugänglich sind, die bei nahezu unverändertem Seebeck-Koeffizienten eine deutlich verringerte Wärmeleitfähigkeit und einen erheblich gesteigerten thermoelektrischen Wirkungsgrad zeigen. Die elektrische Leitfähigkeit wird bei niedrigen Temperaturen nur geringfügig reduziert.

Das erfindungsgemäße Verfahren kann beispielsweise wie in WO 01/17034 beschrieben durchgeführt werden. Speziell geeignete Verfahren sind beispielsweise in J. Appl. Phys. Vol. 92, No. 5, September 2002, Seiten 2610 bis 2613, der eingangs genannten Literaturstelle von F. Belanger, J.-M. Simard, 22. International Conference on Thermoelectrics (2003), Seiten 13 bis 18 beschrieben. Alternative Verfahren sind in US 3,220,199 oder US 4,161,111 beschrieben.

Ausgegangen wird von Bleichalcogeniden, wie PbS, PbSe oder PbTe. Bevorzugt wird PbTe eingesetzt. Die Bleichalcogenide, insbesondere Bleitellurid, können in n- und p-Dotierung eingesetzt werden. Geeignete Dotierungen im Verfahren zur Herstellung der Ausgangsmaterialien sind beispielsweise in WO 2007/104601 beschrieben.

Erfindungsgemäß wird bevorzugt ohne Flussmittel gearbeitet. Bevorzugt wird mit isostatischer Extrusion gearbeitet.

Dopanden sind beispielsweise ausgewählt aus der Gruppe der Elemente Li, Na, K, Rb, Cs, Be, Mg, Ca, Sr, Ba, Al, Ga, In, Tl, Si, Ge, Sn, As, Sb, Bi, S, Se, Br, I, Sc, Y, La, Ti, Zr, Hf, V, Nb, Ta, Cr, Mo, W, Mn, Re, Fe, Ru, Os, Co, Rh, Ir, Ni, Pd, Pt, Cu, Ag, Au, Zn, Cd, Hg, Ce, Pr, Nd, Sm, Eu, Gd, Tb, Dy, Ho, Er, Tm, Yb, Lu, vorzugsweise ausgewählt aus der Gruppe der Elemente

Al, In, Si, Ge, Sn, Sb, Bi, Se, Ti, Zr, Hf, Nb, Ta, Cu, Ag, Au,

insbesondere ausgewählt aus der Gruppe der Elemente

In, Ge, Ti, Zr, Hf, Nb, Ta, Cu, Ag oder ausgewählt aus Ti, Zr, Ag, Hf, Cu, Ge, Nb, Ta.

Es ist dabei möglich, dass ausgehend von PbTe formal

- Pb oder Te durch einen oder mindestens zwei Dopanden ersetzt werden oder
- ein oder mindestens zwei Dopanden zu PbTe zugegeben werden oder
- ein oder mindestens zwei Dopanden Teile der Pb- oder Te-Positionen übernehmen,

wobei jeweils das Verhältnis von Pb:Te - ausgehend von 1:1 - sich ändert.

Für die erfindungsgemäßen Materialien der Serie werden typischerweise für p-Leiter Seebeck-Koeffizienten im Bereich von im Allgemeinen 150 bis 400 $\mu$V/K, und für n-Leiter im Allgemeinen von -150 bis -400 $\mu$V/K erreicht. Die erzielten Powerfaktoren bei Raumtemperatur betragen im Allgemeinen wenigstens 20 $\mu$W / K$^2$·cm.

Die Auswahl spezieller geeigneter Dopanden und chemischer Zusätze zur Einstellung von Ladungsträgerkonzentration und Ladungsträgermobilität ist dem Fachmann bekannt. Dazu kann beispielsweise Tellur in jedem Fall ganz oder teilweise durch Selen und/oder teilweise durch Schwefel ersetzt werden.

Die Einsatztemperaturen der Bleitelluride in thermoelektrischen Materialien betragen üblicherweise von 250 bis 600 °C. Es gibt aber auch Bleitelluridmaterialien, die auch unterhalb von 250°C, z. B. bei Raumtemperatur eingesetzt werden können.

Das eingesetzte thermoelektrische Material kann durch Schmelzsynthese oder Vermischen von Element- oder Legierungspulvern hergestellt werden.

Die thermoelektrisch aktiven Materialien werden meist aus der Schmelze, durch mechanical alloying oder durch ähnliche Verfahren synthetisiert. Dabei ist anschließend häufig noch ein Verarbeitungsschritt notwendig, der die Materialien weiter kompaktiert. Konventionell dient hierzu das Mahlen und anschließende (Heiß)pressen. Dabei soll nicht nur das Material an sich weiter kompaktiert und verdichtet werden, durch die Neuorientierung der Körner und morphologische Einflüsse lassen sich die Wärmeleitfähigkeit, die möglichst niedrig sein soll, und die elektrische Leitfähigkeit, die möglichst groß sein soll, günstig beeinflussen, während der dritte wichtige Parameter, der Seebeck-Koeffizient, sich auf diese Weise kaum variieren lässt.

Die erfindungsgemäß zur Extrusion eingesetzten Materialien werden im Allgemeinen durch Reaktivmahlen oder bevorzugt durch Zusammenschmelzen und Reaktion von Mischungen der jeweigen Elementbestandteile oder deren Legierungen hergestellt. Dabei hat sich im Allgemeinen eine Reaktionszeit des Reaktivmahlens oder bevorzugt Zusammenschmelzens von mindestens einer Stunde als vorteilhaft herausgestellt.

Das Zusammenschmelzen und Reagieren erfolgt vorzugsweise während eines Zeitraumes von mindestens 1 Stunde, besonders bevorzugt mindestens 6 Stunden, insbesondere mindestens 10 Stunden. Der Schmelzprozess kann mit oder ohne Vermischung der Ausgangsmischung erfolgen. Wenn die Ausgangsmischung vermischt wird, so eignet sich hierfür insbesondere ein Dreh- oder Kippofen, um die Homogenität der Mischung zu gewährleisten.

Falls keine Mischung vorgenommen wird, so sind im Allgemeinen längere Schmelzzeiten erforderlich, um ein homogenes Material zu erhalten. Falls eine Mischung vorgenommen wird, so wird die Homogenität in der Mischung bereits früher erhalten.

Ohne zusätzliches Mischen der Ausgangsmischungen beträgt die Schmelzzeit im Allgemeinen 2 bis 50 Stunden, insbesondere 30 bis 50 Stunden.

Das Zusammenschmelzen erfolgt im Allgemeinen bei einer Temperatur, bei der mindestens ein Bestandteil der Mischung bereits geschmolzen ist und sich das Material bereits im geschmolzenen Zustand befindet. Im Allgemeinen beträgt die Schmelztemperatur mindestens 800 °C, vorzugsweise mindestens 950 °C. Üblicherweise liegt die Schmelztemperatur in einem Temperaturbereich von 800 bis 1100 °C, vorzugsweise 950 bis 1050 °C.

Nach dem Abkühlen der geschmolzenen Mischung ist es vorteilhaft, das Material bei einer Temperatur von im Allgemeinen mindestens 100 °C, vorzugsweise mindestens 200 °C, niedriger als der Schmelzpunkt des resultierenden Halbleitermaterials zu tempern. Üblicherweise beträgt die Temperatur 450 bis 750 °C, vorzugsweise 550 bis 700 °C.

Das Tempern wird während eines Zeitraumes von vorzugsweise mindestens 1 Stunde, besonders bevorzugt mindestens 2 Stunden, insbesondere mindestens 4 Stunden, durchgeführt. Üblicherweise beträgt die Temperzeit 1 bis 8 Stunden, vorzugsweise 6 bis 8 Stunden. In einer Ausführungsform der vorliegenden Erfindung wird das Tempern bei einer Temperatur durchgeführt, welche 100 bis 500 °C niedriger ist als die Schmelztemperatur des resultierenden Halbleitermaterials. Ein bevorzugter Temperaturbereich ist 150 bis 350 °C niedriger als der Schmelzpunkt des resultierenden Halbleitermaterials.

Die Herstellung der erfindungsgemäß zu extrudierenden thermoelektrischen Materialien erfolgt im Allgemeinen in einem evakuierten und verschlossenen Quarzrohr. Eine Vermischung der beteiligten Komponenten kann durch Verwendung eines drehund/oder kippbaren Ofens gewährleistet werden. Nach Vervollständigung der Umsetzung wird der Ofen abgekühlt. Im Anschluss wird das Quarzrohr aus dem Ofen entnommen und das in Form von Blöcken vorliegende Halbleitermaterial zerkleinert.

Anstelle eines Quarzrohres können auch Rohre oder Ampullen aus anderen gegenüber dem Halbleitermaterial inerten Materialien, beispielsweise aus Tantal, verwendet werden.

Anstelle von Rohren oder Ampullen können auch andere Behälter in geeigneter Form verwendet werden. Auch andere Materialien, beispielsweise Graphit, können als Behältermaterial verwendet werden, sofern sie inert gegenüber dem Halbleitermaterial sind.

In einer Ausführungsform der vorliegenden Erfindung kann das abgekühlte Material bei geeigneter Temperatur nass, trocken oder in anderer geeigneter Weise gemahlen werden, so dass das erfindungsgemäße Halbleitermaterial in üblichen Partikelgrößen kleiner als 10 $\mu$m erhalten wird. Das gemahlene erfindungsgemäße Material wird dann heiß extrudiert.

Die Heißextrusion muss bei Temperaturen deutlich oberhalb von Raumtemperatur erfolgen, damit das Material adäquate Fließeigenschaften bekommt und sich extrudieren lässt. Für die erfindungsgemäß eingesetzten Bleichalcogenide, insbesondere Bleitelluride, beträgt die Temperatur bei der Extrusion 500 bis 630 °C, insbesondere 500 bis 560 °C. Der Druck beträgt dabei typischerweise 300 bis 1000 MPa, besonders bevorzugt 500 bis 700 MPa.

Die Extrusion kann dabei als Heißextrusion, hydrostatische Extrusion oder Equal Channel Extrusion durchgeführt werden.

Vor der Extrusion kann nach der Legierungsherstellung und Zerkleinerung wahlweise noch eine Kompaktierung und wahlweise eine Wärmebehandlung durchgeführt werden, wie sie beispielsweise in WO 01/17034 auf Seite 11 und 12 beschrieben sind.

Die Extrusionsbehandlung kann vom direkten oder indirekten Typ sein. In beiden Fällen wird die Legierung in den Extrusionszylinder gefüllt. Das Aufheizen kann direkt im Extrusionszylinder oder in einem separaten Ofen erfolgen. Beim Aufheizen soll ein Kontakt mit der Umgebungsatmosphäre jedoch verhindert werden. Die Extrusion wird vorzugsweise unter Schutzgas durchgeführt, bevorzugt mit einem Inertgas oder reduzierenden Gas oder einem Gemisch davon. Bevorzugt wird ein Gas eingesetzt, ausgewählt aus Argon, Stickstoff und Mischungen davon. Die Extrusion selbst kann vorzugsweise wie in WO 01/17034 auf den Seiten 12 bis 14 beschrieben durchgeführt werden. Bei der Extrusion wird in einem kontinuierlichen Prozess eine Kompaktierung erreicht, die zu Werten von vorzugsweise mehr als 99 % der theoretischen Dichte führt. Eine Verarbeitung in der Schmelze führt üblicherweise nur zu einer Dichte im Bereich von etwa 90 % der theoretischen Dichte.

Nach der Extrusion kann sich noch eine Wärmebehandlung anschließen, um Spannungen im Material zu beseitigen.

Die Extrusion kann zu beliebigen gewünschten Querschnitts-Geometrien des Extrudates führen, beispielsweise bezogen auf den Durchmesser und die Form des Querschnitts, hierdurch kann die Weiterverarbeitung zu einem thermoelektrischen Modul erheblich vereinfacht werden. Durch Extrusion hergestellte Stäbe oder Stränge können beispielsweise zersägt und poliert werden, wodurch die Herstellung beliebiger Bauteile möglich wird.

Alternativ zur üblichen Extrusion kann auch eine hydrostatische Extrusion erfolgen, bei der über eine Flüssigkeit Druck von mehreren Seiten auf das zu extrudierende Material ausgeübt wird. Ein geeignetes Verfahren zur hydrostatischen Extrusion ist beispielsweise in US 4,161,111 beschrieben.

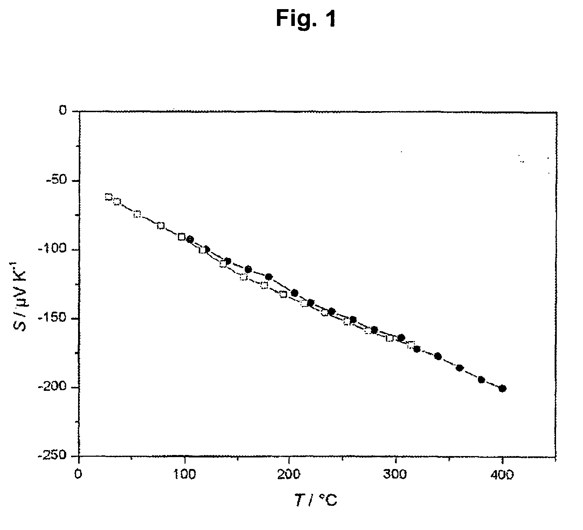

Ferner kann die Equal Channel Extrusion durchgeführt werden, bei der das Extrudat um eine Biegung oder Ecke während der Extrusion geschoben oder gedrückt wird. Ein geeignetes Verfahren ist beispielsweise in Acta Materialia 52 (2004), Seiten 49 bis 55 beschrieben. Für das Herstellungsschema kann insbesondere auf Figur 1 auf Seite 50 verwiesen werden.

Das erfindungsgemäße Verfahren erlaubt durch Heißextrusion die Herstellung eines kompakten, homogenen Materials, wobei die Dichte auf Werte von mehr als 99 %, beispielsweise bis auf 99,9 % der theoretischen Dichte erhöht werden kann.

Das Extrudat ist, auch im Hinblick auf eine kontinuierliche Prozessführung und den Modulbau, hervorragend verarbeitbar, beispielsweise durch Sägen.

Der Seebeck-Koeffizient wird nicht signifikant verändert, das heißt die zugrunde liegende chemische Zusammensetzung und die Phasenverhältnisse des Materials werden nicht verändert, sondern lediglich die Morphologie, etwa die Korngrößenverteilung und die Korngrenzen.

Die elektrische Leitfähigkeit wird geringfügig reduziert, was aber nur bei niedrigen Temperaturen ins Gewicht fällt.

Die Wärmeleitfähigkeit wird deutlich verringert, über den gesamten Temperaturbereich. Ohne an eine Theorie gebunden zu sein, wird davon ausgegangen, dass diese Verringerung durch eine zumindest teilweise Entkopplung von Gitteranteil und elektronischem Anteil der Wärmeleitfähigkeit ermöglicht wird, was über eine rein chemische Modifikation des Materials alleine nicht möglich wäre.

Die Wärmeleitfähigkeit hat insgesamt auch den größten Einfluss auf die beobachtete Steigerung des thermoelektrischen Wirkungsgrads.

Die erfindungsgemäßen Halbleitermaterialien können auch nach Methoden zu thermoelektrischen Generatoren oder Peltier-Anordnungen zusammengefügt werden, welche dem Fachmann an sich bekannt sind und beispielsweise in WO 98/44562, US 5,448,109, EP-A- 1102 334 oder US 5,439,528 beschrieben sind.

Die erfindungsgemäßen thermoelektrischen Generatoren oder Peltier-Anordnungen erweitern im Allgemeinen die vorhandene Bandbreite an thermoelektrischen Generatoren und Peltier-Anordnungen. Durch Variation der chemischen Zusammensetzung der thermoelektrischen Generatoren oder Peltier-Anordnungen ist es möglich, unterschiedliche Systeme bereitzustellen, welche unterschiedlichen Anforderungen in einer Vielzahl an Anwendungsmöglichkeiten gerecht werden. Damit erweitern die erfindungsgemäßen thermoelektrischen Generatoren oder Peltier-Anordnungen das Anwendungsspektrum dieser Systeme.

Die vorliegende Erfindung betrifft auch die Verwendung eines erfindungsgemäßen thermoelektrischen Generators oder einer erfindungsgemäßen Peltier-Anordnung

- als Wärmepumpe
- zur Klimatisierung von Sitzmöbeln, Fahrzeugen und Gebäuden
- in Kühlschränken und (Wäsche)trocknern
- zur simultanen Heizung und Kühlung von Stoffströmen bei Verfahren der Stofftrennung wie

  - Absorption
  - Trocknung
  - Kristallisation
  - Verdampfung
  - Destillation

- als Generator zur Nutzung von Wärmequellen wie

  - solarer Energie
  - Erdwärme
  - Verbrennungswärme fossiler Brennstoffe
  - von Abwärmequellen in Fahrzeugen und stationären Anlagen
  - von Wärmesenken beim Verdampfen flüssiger Stoffe
  - biologischer Wärmequellen

- zur Kühlung elektronischer Bauteile

Die Erfindung betrifft auch die Verwendung der Extruder zur Verminderung der Wärmeleitfähigkeit und zur Erhöhung des thermoelektrischen Wirkungsgrads der thermoelektrischen Materialien bei der Extrusion der thermoelektrischen Materialien.

Die vorliegende Erfindung wird anhand des nachfolgend beschriebenen Beispiels näher erläutert.

**Beispiel**

Extrusion von Bleitellurid

Die Extrusion wurde in einem diskontinuierlichen Kolbenextruder durchgeführt. Der Innendurchmesser des Extruders betrug 3,5 cm. Durch die Extrusionsmatrize wurde eine konische Verjüngung auf einen Durchmesser von 0,79 cm erzielt. Sämtliche Arbeiten einschließlich der eigentlichen Extrusion fanden unter Argon als Schutzgas statt.

Das Startmaterial, n-Bleitellurid, wurde durch Schmelzsynthese hergestellt (mittlere Dichte: 94,6 % der Theorie) und in Stücke von 1 mm bis 10 mm Größe zerkleinert. Diese Stücke wurden direkt zur Extrusion eingesetzt. Der Extruder wurde auf 530 °C erhitzt, und das Material wurde mit einem Druck von 610 MPa extrudiert. Zur Extrusion von 240 g Startmaterial wurden rund 60 min benötigt.

Erhalten wurde ein metallisch glänzender, kompakter und völlig gleichförmig erscheinender zylindrischer Formkörper. Die Dichte betrug 99,9 % der Theorie.

Der Formkörper wurde mit einer Diamantdrahtsäge in Scheiben (Dicke 1,5 mm) geschnitten. Im Querschnitt der Proben konnten unter dem Lichtmikroskop keinerlei Risse, Löcher oder Lunker beobachtet werden, ebenso auch keine Inhomogenitäten, abgegrenzte Kristallite oder erkennbare Korngrenzen.

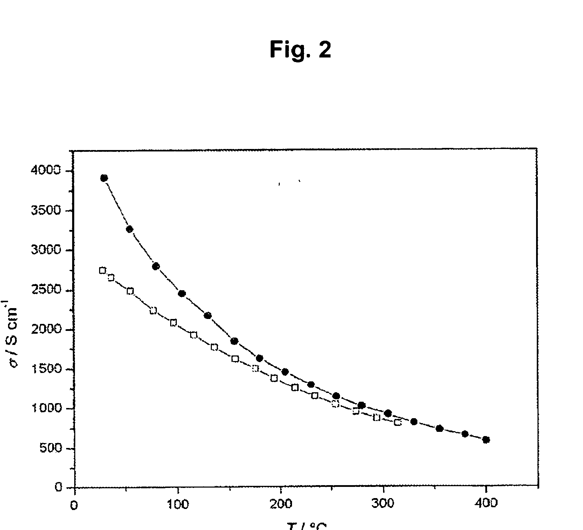

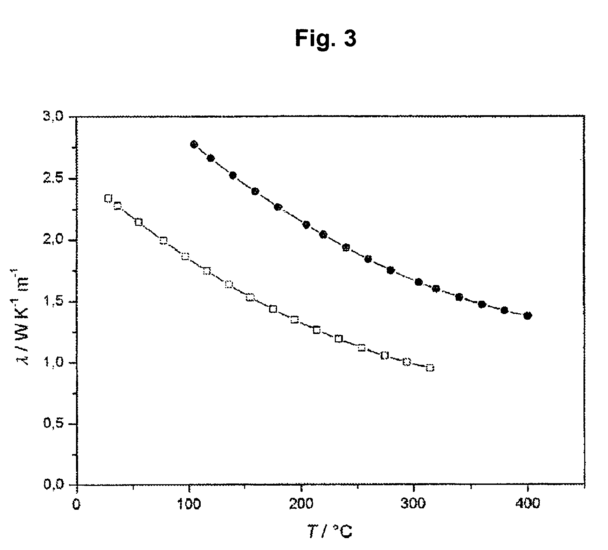

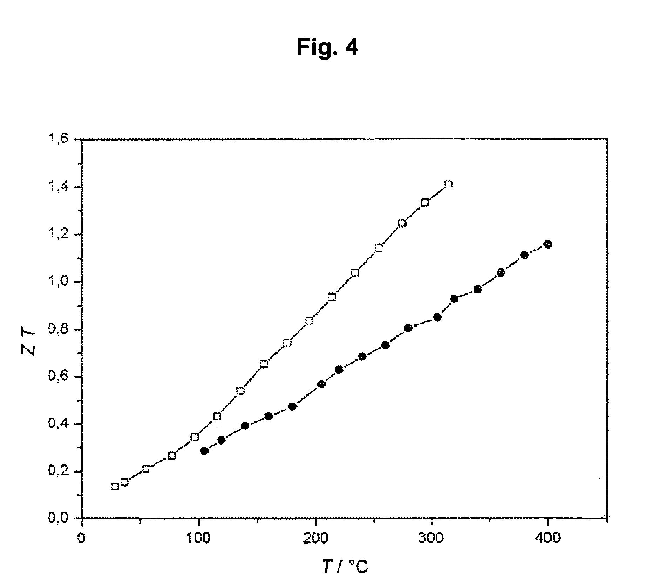

Die thermoelektrische Charakterisierung ergab die in den Abbildungen 1 - 4 im Vergleich mit dem Startmaterial gezeigten Messwerte.

**Messungen**

Der Seebeck-Koeffizient wird dadurch bestimmt, dass das zu untersuchende Material zwischen einen heißen und einen kalten Kontakt, welche jeweils elektrisch temperiert werden, gelegt wird, wobei der heiße Kontakt eine Temperatur von 200 bis 300 °C aufweist. Die kalte Seite wird auf Raumtemperatur gehalten, so dass ein $\Delta T$ von typischerweise 150 bis 280 °C resultiert. Die gemessene Spannung bei der jeweiligen Temperaturdifferenz zwischen heißem und kaltem Kontakt liefert den jeweils angegebenen Seebeck-Koeffizienten.

Die elektrische Leitfähigkeit wird bei Raumtemperatur durch eine Vierpunkt-Messung bestimmt. Das Verfahren ist dem Fachmann bekannt.

| Ausgefüllte Kreise | = | n-PbTe vor Extrusion |
|---|---|---|
| Leere Quadrate | = | n-PbTe nach Extrusion |

Aus den Abbildungen ergibt sich deutlich, dass sich der Seebeck-Koeffizient nicht signifikant durch die Extrusion verändert. Die elektrische Leitfähigkeit sinkt insbesondere für niedrige Temperaturen. Die Wärmeleitfähigkeit ist bei allen Temperaturen signifikant vermindert. Der thermoelektrische Wirkungsgrad steigt stark, insbesondere für höhere Temperaturen.

| Abbildung 1: | Seebeck-Koeffizient in Abhängigkeit der Temperatur |
|---|---|
| Abbildung 2: | Elektrische Leitfähigkeit in Abhängigkeit der Temperatur |
| Abbildung 3: | Wärmeleitfähigkeit in Abhängigkeit der Temperatur |
| Abbildung 4: | Thermoelektrischer Wirkungsgrad in Abhängigkeit der Temperatur |

**Patentansprüche**

1. Verfahren zur Verminderung der Wärmeleitfähigkeit und zur Erhöhung des thermoelektrischen Wirkungsgrads von thermoelektrischen Materialien auf Basis von Bleichalcogeniden, **dadurch gekennzeichnet, dass** die thermoelektrischen Materialien bei einer Temperatur unterhalb ihres Schmelzpunktes und einem Druck im Bereich von 300 bis 1000 MPa extrudiert werden und die Temperatur bei der Extrusion 500 bis 630 °C beträgt.

2. Verfahren nach Anspruch 1, **dadurch gekennzeichnet, dass** die Temperatur bei der Extrusion 500 bis 560 °C beträgt.

**3.** Verfahren nach einem der Ansprüche 1 oder 2, **dadurch gekennzeichnet, dass** der Druck 500 bis 700 MPa beträgt.

**4.** Verfahren nach einem der Ansprüche 1 bis 3, **dadurch gekennzeichnet, dass** das Bleichalcogenid PbTe ist, das n- oder p-dotiert sein kann.

**5.** Verfahren nach einem der Ansprüche 1 bis 4, **dadurch gekennzeichnet, dass** die Extrusion als Heißextrusion, hydrostatische Extrusion oder Equal Channel Extrusion durchgeführt wird.

**6.** Verfahren nach einem der Ansprüche 1 bis 5, **dadurch gekennzeichnet, dass** das eingesetzte thermoelektrische Material durch Schmelzsynthese oder Vermischen von Element- oder Legierungspulvern hergestellt wurde.

**Claims**

**1.** A process for reducing the thermal conductivity and for increasing the thermoelectric efficiency of thermoelectric materials based on lead chalcogenides, wherein the thermoelectric materials are extruded at a temperature below their melting point and a pressure in the range from 300 to 1000 MPa and wherein the temperature in the extrusion is from 500 to 630°C.

**2.** The process according to claim 1, wherein the temperature in the extrusion is from 500 to 560°C.

**3.** The process according to either of claims 1 and 2, wherein the pressure is from 500 to 700 MPa.

**4.** The process according to any one of claims 1 to 3, wherein the lead chalcogenide is PbTe which may be n- or p-doped.

**5.** The process according to any one of claims 1 to 4, wherein the extrusion is performed as a hot extrusion, hydrostatic extrusion or equal channel extrusion.

**6.** The process according to any one of claims 1 to 5, wherein the thermoelectric material used has been prepared by melt synthesis or mixing of element or alloy powders.

**Revendications**

**1.** Procédé de réduction de la conductivité thermique et d'augmentation du degré d'action thermoélectrique de matériaux thermoélectriques à base de chalcogénures de plomb, **caractérisé en ce que** les matériaux thermoélectriques sont extrudés à une température inférieure à leur point de fusion et à une pression dans la plage allant de 300 à 1 000 MPa et la température lors de l'extrusion est de 500 à 630 °C.

**2.** Procédé selon la revendication 1, **caractérisé en ce que** la température lors de l'extrusion est de 500 à 560 °C.

**3.** Procédé selon l'une quelconque des revendications 1 ou 2, **caractérisé en ce que** la pression est de 500 à 700 MPa.

**4.** Procédé selon l'une quelconque des revendications 1 à 3, **caractérisé en ce que** le chalcogénure de plomb est PbTe, qui peut être dopé par un dopage de type n ou p.

**5.** Procédé selon l'une quelconque des revendications 1 à 4, **caractérisé en ce que** l'extrusion est réalisée sous la forme d'une extrusion à chaud, d'une extrusion hydrostatique ou d'une extrusion à canaux égaux (Equal Channel Extrusion).

**6.** Procédé selon l'une quelconque des revendications 1 à 5, **caractérisé en ce que** le matériau thermoélectrique utilisé a été fabriqué par synthèse à l'état fondu ou mélange de poudres d'éléments ou d' alliages.

# Fig. 1

# Fig. 2

# Fig. 3

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0117034 A
- US 3220199 A
- US 4161111 A
- US 3285019 A
- EP 0115950 A
- WO 2007104601 A
- WO 9844562 A
- US 5448109 A
- EP 1102334 A
- US 5439528 A

**In der Beschreibung aufgeführte Nicht-Patentliteratur**

- *Mat. Sci. and Eng.,* 1995, vol. B29, 228
- **F. Belanger et al.** Advances In Powder Metallurgy & Particulate Materials - 2001. *Proceedings of the 2001 International Conference on Powder Metallurgy & Particulate Materials,* 13. Mai 2001, 9-889-98
- *J. Appl. Phys.,* September 2002, vol. 92 (5), 2610-2613
- **F. Belanger ; J.-M. Simard.** *International Conference on Thermoelectrics,* 2003, vol. 22, 13-18
- *Acta Materialia,* 2004, vol. 52, 49-55